# EUROPÄISCHE PATENTSCHRIFT

(11) **EP 0 669 005 B1**
(45) Veröffentlichungstag und Bekanntmachung des Hinweises auf die Patenterteilung: **23.04.1997**
(21) Anmeldenummer: 93923442.3
(22) Anmeldetag: 26.10.1993
(51) Int. Cl.: G01S 13/62

(54) **MIKROWELLEN-DOPPLERMODUL**
MICROWAVE DOPPLER MODULE
MODULE DOPPLER A MICRO-ONDES

(30) Priorität: 10.11.1992 DE 4237908
(43) Veröffentlichungstag der Anmeldung: 30.08.1995
(73) Patentinhaber: SIEMENS AKTIENGESELLSCHAFT, 80333 München (DE)
(72) Erfinder: SCHUBERT, Richard, D-81739 München (DE)
(86) Internationale Anmeldenummer: DE9301018
(87) Internationale Veröffentlichungsnummer: WO9411755

(56) Entgegenhaltungen:
- EP-A- 0 370 965
- US-A- 4 499 467
- PATENT ABSTRACTS OF JAPAN vol. 5, no. 154 (P-082)29. September 1981 & JP,A,56 086 375 (MITSUBISHI) 14. Juli 1981

## Beschreibung

Die vorliegende Erfindung betrifft einen Dopplersensor, der im Mikrowellenbereich arbeitet und insbesondere für die Geschwindigkeitsmessung von Fahrzeugen vorgesehen ist.

Für die Entwicklung von Systemen zur Traktions- und Bremskraftregelung sowie zur genauen Wegstreckenerfassung für Ortungssysteme werden präzise und zuverlässige Weg- und Geschwindigkeitsmesser benötigt. Dies trifft insbesondere für die Automobil- und Eisenbahntechnik zu. Bei der bislang üblichen Auswertung der Radumdrehungen begrenzen Schlupf und Veranderungen des Raddurchmessers die Genauigkeit. Die berührungslose Messung nach dem Dopplerprinzip liefert bessere Resultate. Der Einsatz der Doppler-Geschwindigkeitsmessung scheiterte bisher an Zuverlassigkeitsproblemen bei ungünstigen Betriebsbedingungen. Diese können durch verbesserte Dopplermoduln, störunempfindliche rechnerische Auswertungen sowie durch beispielsweise die Kombination von Mikrowellen und Ultraschall eliminiert werden. Bei Mikrowellensensoren nach dem Dopplerprinzip geht in das Gesamtrauschverhalten neben dem Rauschen im Empfangsteil auch das Rauschen des ausgesendeten Signals ein. Daher ist dem Rauschverhalten des das Sendesignal erzeugenden Generators besondere Aufmerksamkeit zu widmen. Es hat sich gezeigt, daß preisgünstig und platzsparend herzustellende Mikrowellengeneratoren mit FETs und dielektrischen Resonatoren in Mikrostriptechnik wesentlich stärker rauschen als z. B. Gunn-Oszillatoren, die meist in konventioneller Hohlleitertechnik eingesetzt werden.

Um diesem Problem des starken Rauschens des Generatorsignales zu begegnen, wird z. B. an rauscharmen Überlagerungsempfängern gearbeitet, die aber den Gesamtaufwand sehr vergrößern. Eine andere Möglichkeit, den negativen Einfluß eines rauschenden Generatorsignals zu umgehen, besteht darin, das Amplitudenrauschen des Generators mit zu detektieren und durch eine geeignete Operation (Division, Subtraktion) aus dem aus der Messung resultierenden Signal zu eliminieren. Dieses Prinzip liegt auch den balanzierten Mischern (balanced mixers) zugrunde, die es erlauben, Amplitudenschwankungen des Generatorsignals im wesentlichen zu kompensieren. In der Praxis wird in Dopplermoduln häufig zusätzlich ein um 90° phasenverschobenes Signal benötigt, um die Bewegungsrichtung bestimmen zu können. In einer solchen Anordnung, wie sie z.B. in der US 4,499,467 beschrieben ist, bräuchte man zur Rauschunterdrückung durch Mischer mindestens vier Dioden, die den konstruktiven Aufwand beträchtlich erhöhen und einen größeren Teil der Generatorleistung absorbieren würden.

Aufgabe der vorliegenden Erfindung ist es, einen Mikrowellen-Dopplermodul anzugeben, bei dem das Generatorrauschen wirkungsvoll unterdrückt ist, ohne daß sich Einbußen beim Meßresultat ergeben.

Diese Aufgabe wird mit dem Dopplersensor mit den Merkmalen des Anspruches 1 gelöst. Weitere Ausgestaltungen ergeben sich aus den abhängigen Ansprüchen.

Bei einem Dopplersensor, der mit zwei Dioden zwei um 90° phasenverschobene Signale liefert, tritt das generatorbedingte Amplitudenrauschen in beiden Signalen kohärent auf. Bei der erfindungsgemäßen Anordnung wird die Differenz beider Signale gebildet. Dadurch erhält man ein erheblich rauschärmeres Dopplersignal, das nur den Betrag der Geschwindigkeit liefert. Die Information über die Bewegungsrichtung, d. h. die Orientierung der Bewegung bezüglich der Senderichtung, kann in konventioneller Weise aus beiden Einzelsignalen gewonnen werden, wie das z. B. in der Veröffentlichung von P. Heide e. a.:"Berührungslose Geschwindigkeitsmessung nach dem Dopplerprinzip mit Ultraschall und Mikrowellen" in VDI-Berichte 939 zur sechsten GMA/ITG-Fachtagung "Sensoren - Technologie und Anwendung", Bad Nauheim, 16. bis 18.03.1992, beschrieben ist. Da sich die Bewegungsrichtung nur selten ändert, kann die Information über die Richtung der Bewegung mit erheblich geringerer Bandbreite ausgewertet werden und ist entsprechend unempfindlich gegenüber Rauschen.

Ist es für die gegebene Anwendung nötig, beide Einzelsignale sehr rauscharm zu gewinnen, so besteht eine andere Ausprägungsform der Erfindung in der Verwendung einer dritten Diode, die zusätzlich ein um 180° phasenverschobenes Signal bezüglich der ersten Diode liefert. Es können somit zwei unabhängige Differenzsignale gewonnen werden, die weitgehend von Generatorrauschen frei sind und relativ zueinander die Richtungsinformation enthalten. Diese Anordnung ist in den Rauscheigenschaften zum oben erwähnten System mit zwei Mischern (z. B. die angegebenen balanzierten Mischer) identisch, benötigt aber eine Diode weniger und ist somit einfacher herstellbar und absorbiert weniger Mikrowellenleistung in den Dioden.

Die Differenzbildung kann in den erfindungsgemäßen Anordnungen sowohl durch Differenzverstärker bzw. durch entsprechende NF-Auskopplung aus dem Verteilernetzwerk (gegeneinander arbeitende Dioden) geschehen als auch durch digitale Signalverarbeitung.

Es folgt eine Beschreibung der erfindungsgemäßen Dopplersensoren anhand der Figuren 1 bis 3.
- Fig. 1: zeigt eine erste Ausführungsform der erfindungsgemäßen Anordnung mit gesondertem Phasenschieberteil im Schema.
- Fig. 2: zeigt einen besonders einfachen Aufbau der Anordnung aus Fig. 1.
- Fig. 3: zeigt eine gegenüber der Anordnung von Fig. 2 verbesserte Ausführungsform im Schema.

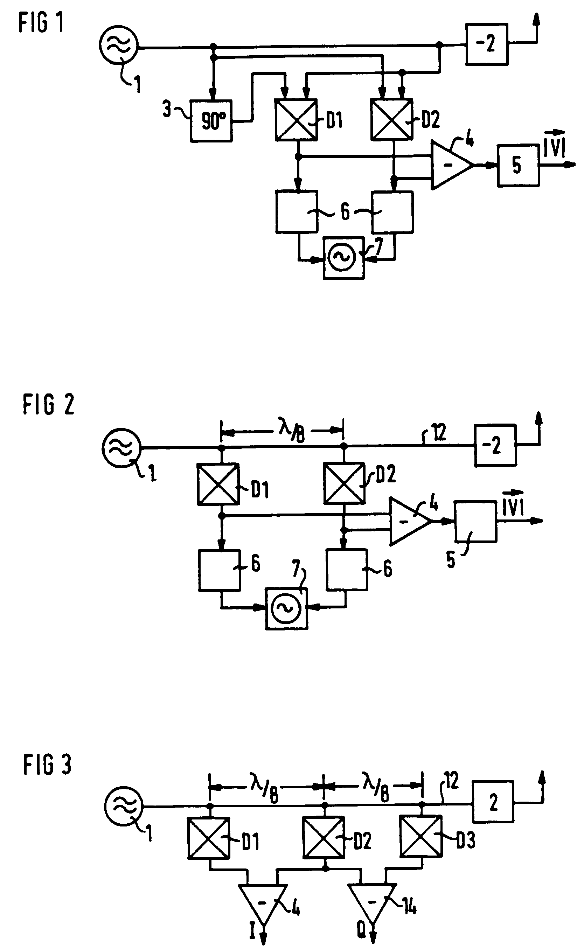

In Fig. 1 ist ein Frequenzgenerator 1 dargestellt, der elektromagnetische Wellen vorzugsweise im Wellenlangenbereich von 1 mm bis 100 mm erzeugt. Diese Wellen werden von der Sendeund Empfangseinheit (2) ausgesendet und nach Reflexion von einem relativ zu dem Dopplersensor bewegten Objekt wieder empfangen. Das empfangene Signal wird den beiden Mischern D1, D2 zugeführt. Diesen Mischern D1, D2 wird ebenfalls jeweils das Generatorsignal zugeführt. In einen der Signalwege, in Fig. 1 zwischen Frequenzgenerator 1 und ersten Mischer D1, ist ein Phasenschieber 3 eingebaut. Dieser Phasenschieber 3 erzeugt eine Phasenverschiebung des Signales um 90°. Die Phasenverschiebung muß nicht exakt 90° betragen. Als Mischer kommen vorwiegend nichtlineare Bauelemente, wie sie in der Elektrotechnik üblich sind, in Frage. Als besonders einfache und billige Ausführung kommen Dioden in Frage.

Die in den Mischern erzeugte Überlagerung enthält eine Zwischenfrequenz, die die Differenz der Frequenz des Generatorsignals und der dopplerverschobenen Frequenz des reflektierten und wieder empfangenen Signales darstellt. Diese Zwischenfrequenz ist daher ein Maß für die Dopplerverschiebung und kann in einer Auswerteeinheit 5 zur Ermittlung des zu messenden Geschwindigkeitsbetrages verwendet werden. Ggf. kann in der Auswerteeinheit 5 auch rechnerisch berücksichtigt werden, wenn die Relativgeschwindigkeit zwischen dem Dopplersensor und dem reflektierenden Objekt nicht gleich der Fahrgeschwindigkeit des Fahrzeuges ist, an dem dieser Dopplersensor montiert ist. Erfindungsgemaß ist zwischen den Mischern D1, D2 und dieser Auswerteeinheit 5 ein Differenzglied 4 geschaltet. In diesem Differenzglied 4 wird die Differenz der beiden von den zwei Mischern D1, D2 gelieferten Signale ermittelt. Durch die mit dem Phasenschieber 3 bewirkte Phasenverschiebung enthält dieses Differenzsignal nach wie vor einen Anteil der Zwischenfrequenz, während der Rauschanteil, der von dem ursprünglichen Generatorsignal herrührt weitestgehend eliminiert ist.

Die von den Mischern D1, D2 kommenden Signale können für die Auswertung der Richtungsinformation wie üblich je auf einen Tiefpaß 6 gegeben werden, der die Zwischenfrequenz passieren läßt und die höheren Frequenzen ausfiltert, so daß die Ausgangssignale dieser Tiefpaßfilter 6 z. B. auf einen Oszillographen 7 zweidimensional als Kreisbewegung dargestellt werden können und aus dem Drehsinn die Orientierung der Relativbewegung der zu messenden Geschwindigkeit abgelesen werden kann.

Der Phasenschieber 3 kann im Prinzip in jedem der insgesamt vier den Mischern D1, D2 zugeführten Leitungen eingeschaltet sein. Die Phasenverschiebung kann daher statt zwischen den direkt vom Frequenzgenerator 1 kommenden Signalen auch zwischen den beiden reflektierten Frequenzen vorgenommen werden. Eine vereinfachte Anordnung ist in Fig. 2 dargestellt, bei der auf einen Phasenschieber 3 ganz verzichtet werden kann. Bei dieser Anordnung nach Fig. 2 befindet sich zwischen dem Frequenzgenerator 1 und der Sende- und Empfangseinheit 2 ein Wellenleiter sowohl für die hinlaufende als auch für die reflektierte und zurücklaufende Welle gemeinsam. Auf diesem Wellenleiter 12 kann die Signalwelle an zwei verschiedenen Punkten im Abstand einer achtel Wellenlänge abgegriffen werden. Wenn man davon ausgeht, daß die Amplitude des reflektierten Signales so klein ist, daß sie rechnerisch gegenüber der Amplitude des von dem Frequenzgenerator 1 ausgesandten Signales vernachlässigt werden kann, so erhält man bei diesem Abgreifen der Frequenzen im Abstand von zumindest näherungsweise einer achtel Wellenlänge des ausgesandten Signales eine Phasenverschiebung von etwa 90° zwischen den an den Eingängen der Mischer D1, D2 anliegenden Summensignalen. Wie erwähnt muß die Phasenverschiebung nicht exakt 90° betragen, so daß an zwei geeigneten Stellen des Wellenleiters sowohl die vom Generator kommenden Frequenzen als auch die dopplerverschobenen reflektierten Frequenzen abgegriffen werden können und damit bei einem Abstand zwischen diesen Abgriffstellen von ungefähr einer achtel Wellenlänge sich die Phasenverschiebung von 90° in ausreichend guter Näherung ergibt. An den Ausgängen der Mischer liegt jeweils ein Überlagerungssignal an, in dem die Differenz des Generatorsignales und der dopplerverschobenen Frequenz des empfangenen Signales als Zwischenfrequenz enthalten ist. Die übrigen Komponenten dieser Anordnung entsprechen denen des in Fig. 1 dargestellten Ausführungsbeispiels. Durch den Verzicht auf eine gesonderte Phasenschiebung ist dieser Aufbau wesentlich einfacher realisierbar als der nach Fig. 1.

Eine weitere Verbesserung ergibt sich gemäß der Anordnung von Fig. 3, bei der in einem weiteren Abstand einer achtel Wellenlänge des vom Frequenzgenerator 1 ausgesandten Signales ein dritter Mischer D3 angeordnet ist. In dem Differenzglied 4 wird die Differenz der Ausgangssignale der ersten Mischer D1, D2 erzeugt, das an dem Ausgang I dieses Differenzgliedes 4 anliegt. Ein weiteres Differenzglied 14 ist vorhanden, um entsprechend die Differenz der Ausgangssignale eines dieser Mischer D2 und des dritten Mischers D3 zu erzeugen. Diese Differenz liegt entsprechend an dem Ausgang Q dieses weiteren Differenzgliedes 14 an. Aus den an diesen Ausgängen I, Q anfallenden Differenzsignalen ist daher jeweils das Rauschen des ursprünglichen Signales des Frequenzgenerators eliminiert, während die Signale zueinander eine Phasenverschiebung von 90° aufweisen. Daher läßt sich hier auch eine Auswertung rauschfreier oder zumindest rauscharmer phasenverschobener Signale vornehmen. Damit ist erfindungsgemaß eine einfach herzustellende Anordnung angegeben, bei der ein Dopplermodul mit herkömmlichen, einfach herstellbaren Bauelementen zwei rauscharme um 90° zueinander phasenverschobene Signale aus einer Messung erzeugen kann.

## Patentansprüche

1. Dopplersensor mit einem Frequenzgenerator (1), mit einer Sende- und Empfangseinheit (2) und mit mindestens zwei Mischern (D1, D2), die mit dem Frequenzgenerator (1) und der Empfangseinheit (2) derart verbunden sind, daß in diesen Mischern (D1, D2) erzeugte Zwischenfrequenzen, die einer Dopplerverschiebung zwischen der ausgesandten und der empfangenen Frequenz entsprechen, zueinander einen Phasenunterschied von 90° haben, dadurch gekennzeichnet,
daß eine Auswerteeinheit (5) vorhanden ist, die aus diesen Zwischenfrequenzen den Betrag einer zu der Dopplerverschiebung gehörenden Geschwindigkeit ermittelt, und
daß diese Auswerteeinheit (5) über ein Differenzglied (4), das die Differenz der Zwischenfrequenzen erzeugt, mit den Mischern (D1, D2) verbunden ist.

2. Dopplersensor nach Anspruch 1,
bei dem ein dritter Mischer (D3) vorhanden ist, der mit dem Frequenzgenerator (1) und der Empfangseinheit (2) derart verbunden ist, daß eine in diesem Mischer (D3) erzeugte Zwischenfrequenz, die einer Dopplerverschiebung zwischen der ausgesandten und der empfangenen Frequenz entspricht, zu den von den anderen Mischern (D1, D2) erzeugten Zwischenfrequenzen Phasenunterschiede von 90° und 180° hat, und bei dem ein weiteres Differenzglied (14) vorhanden ist, das für die Erzeugung der Differenz zwischen der von diesem weiteren Mischer (D3) erzeugten Zwischenfrequenz und der von einem anderen Mischer (D2) erzeugten Zwischenfrequenz vorgesehen ist.

3. Dopplersensor nach Anspruch 1 oder 2,
bei dem mindestens ein Mischer (D1) an den Frequenzgenerator (1) oder an die Empfangseinheit (2) über einen Phasenschieber (3) angeschlossen ist.

4. Dopplersensor nach einem der Ansprüche 1 bis 3,
bei dem die Mischer (D1, D2, D3) im Abstand etwa einer achtel Wellenlänge der vom Frequenzgenerator (1) erzeugten elektromagnetischen Wellen zueinander an einen den Frequenzgenerator (1) mit der Sende- und Empfangseinheit (2) verbindenden Wellenleiter (12) angeschlossen sind.

5. Dopplersensor nach einem der Ansprüche 1 bis 4,
bei dem der Frequenzgenerator (1) elektromagnetische Wellen mit einer Wellenlänge zwischen 1 mm und 100 mm erzeugt.

6. Dopplersensor nach einem der Ansprüche 1 bis 5,
bei dem die Mischer (D1, D2, D3) Dioden sind.

7. Doppelsensor nach einem der Ansprüche 1 bis 6,
bei dem eine weitere Auswerteeinheit (6, 7) vorhanden ist, die aus den von den Mischern (D1, D2) erzeugten Zwischenfrequenzen die Orientierung der zu der Dopplerverschiebung gehörenden Geschwindigkeit bezüglich einer Senderichtung feststellt.

## Claims

1. Doppler sensor having a frequency generator (1), having a transmitting and receiving unit (2) and having at least two mixers (D1, D2) which are connected to the frequency generator (1) and to the receiving unit (2) in such a manner that intermediate frequencies which are produced in these mixers (D1, D2) and correspond to a Doppler shift between the transmitted frequency and the received frequency have a phase difference of 90° with respect to one another, characterized in that an evaluation unit (5) is provided which determines from these intermediate frequencies the magnitude of a speed which is associated with the Doppler shift, and in that this evaluation unit (5) is connected to the mixers (D1, D2) via a subtraction element (4) which produces the difference between the intermediate frequencies.

2. Doppler sensor according to Claim 1, in which a third mixer (D3) is provided which is connected to the frequency generator (1) and to the receiving unit (2) in such a manner that an intermediate frequency which is produced in this mixer (D3) and corresponds to a Doppler shift between the transmitted frequency and the received frequency has phase differences of 90° and 180° with respect to the intermediate frequencies produced by the other mixers (D1, D2), and in which a further subtraction element (14) is provided, which is provided to produce the difference between that intermediate frequency which is produced by this further mixer (D3) and that intermediate frequency which is produced by another mixer (D2).

3. Doppler sensor according to Claim 1 or 2, in which at least one mixer (D1) is connected to the frequency generator (1) or to the receiving unit (2) via a phase shifter (3).

4. Doppler sensor according to one of Claims 1 to 3, in which the mixers (D1, D2, D3) are connected to a waveguide (12), which connects the frequency generator (1) to the transmitting and receiving unit (2), at a distance from one another of about one eighth of the wavelength of the electromagnetic waves which are produced by the frequency generator (1).

5. Doppler sensor according to one of Claims 1 to 4, in which the frequency generator (1) produces electromagnetic waves at a wavelength between 1 mm and 100 mm.

6. Doppler sensor according to one of Claims 1 to 5, in which the mixers (D1, D2, D3) are diodes.

7. Doppler sensor according to one of Claims 1 to 6, in which a further evaluation unit (6, 7) is provided which determines, from the intermediate frequencies which are produced by the mixers (D1, D2), the orientation with respect to a transmission direction of the speed which is associated with the Doppler shift.

## Revendications

1. Module Doppler comprenant un générateur de fréquence (1), une unité émettrice-réceptrice (2) et au moins deux mélangeurs (D1, D2) qui sont reliés au générateur de fréquence (1) et à l'unité réceptrice (2) de telle sorte que des fréquences intermédiaires produites dans ces mélangeurs (D1, D2), qui correspondent à un déplacement Doppler entre les fréquences émise et reçue, présentent l'une par rapport à l'autre une différence de phases de 90°, caractérisé
en ce qu'il existe une unité d'analyse (5) qui détermine, à partir de ces fréquences intermédiaires, la grandeur d'une vitesse associée au déplacement Doppler, et
en ce que cette unité d'analyse (5) est reliée aux mélangeurs (D1, D2) par le biais d'un élément différentiateur (4) qui forme la différence des fréquences intermédiaires.

2. Module Doppler selon la revendication 1,
dans lequel il existe un troisième mélangeur (D3) qui est relié au générateur de fréquence (1) et à l'unité réceptrice (2) de telle sorte qu'une fréquence intermédiaire produite dans ce mélangeur (D3), qui correspond à un déplacement Doppler entre les fréquences émise et reçue, présente par rapport aux fréquences intermédiaires produites par les autres mélangeurs (D1, D2) des différences de phases de 90° et 180°, et dans lequel il existe un élément différentiateur (14) supplémentaire qui est prévu pour former la différence entre la fréquence intermédiaire produite par ce troisième mélangeur (D3) et la fréquence intermédiaire produite par un autre mélangeur (D2).

3. Module Doppler selon la revendication 1 ou 2,
dans lequel au moins un mélangeur (D1) est relié au générateur de fréquence (1) ou à l'unité réceptrice (2) par le biais d'un déphaseur (4).

4. Module Doppler selon l'une des revendications 1 à 3,
dans lequel les mélangeurs (D1, D2, D3) sont reliés, à une distance les uns des autres d'à peu près un huitième de la longueur d'onde des ondes électromagnétiques produites par le générateur de fréquence (1), à un guide d'ondes (12) reliant le générateur de fréquence (1) à l'unité émettrice-réceptrice (2).

5. Module Doppler selon l'une des revendications 1 à 4,
dans lequel le générateur de fréquence (1) produit des ondes électromagnétiques ayant une longueur d'onde comprise entre 1 mm et 100 mm.

6. Module Doppler selon l'une des revendications 1 à 5,
dans lequel les mélangeurs (D1, D2, D3) sont des diodes.

7. Module Doppler selon l'une des revendications 1 à 6,
dans lequel il existe une autre unité d'analyse (6, 7) qui détermine, à partir des fréquences intermédiaires produites par les mélangeurs (D1, D2), l'orientation de la vitesse associée au déplacement Doppler par rapport à une direction d'émission.
